# DEMANDE DE BREVET EUROPEEN

(11) **EP 2 823 736 A1**
(43) Date de publication de la demande: **14.01.2015**
(21) Numéro de dépôt: 14176387.0
(22) Date de dépôt: 09.07.2014
(51) Int. Cl.: A47G 19/22, C03C 17/245, C23C 16/40

(54) **Récipient à action effervescente**

(30) Priorité: 10.07.2013 FR 1356794
(71) Demandeur: ARC International France, 62510 Arques (FR); AcXys Technologies, 38950 Saint Martin Le Vinoux (FR)
(72) Inventeur: Queste, Mathieu, 62510 Arques (FR); Donze, Sébastien, 62510 Arques (FR); Dutroncy, Jérôme, 38950 Saint Martin Le Vinoux (FR); Lanfray, Charlotte, 38950 Saint Martin Le Vinoux (FR)
(74) Mandataire: Cabinet Netter

(57) **Abrégé**

Récipient pour boisson présentant des irrégularités de surface dans une région choisie. La région choisie est revêtue d'une couche hydrophobe (15). Les irrégularités forment des sites de nucléation à l'intérieur du récipient. Les sites de nucléation favorisent la formation de bulles (19) au contact d'une boisson carbonatée (17). Procédé de création de tels sites de nucléation dans un récipient.

## Description

L'invention relève du domaine des récipients pour liquide, et plus particulièrement des articles de gobeleterie.

Lors de la fabrication de récipients pour boissons tel que des gobelets en verre, les surfaces crées sont généralement rendues les plus lisses possibles, notamment pour leur conférer une bonne transparence et pour des raisons esthétiques.

Le service d'une boisson gazeuse dans un récipient génère des phénomènes effervescents, ou du bullage, et l'accumulation de mousse à la surface. Pour le service de bière ou du vin mousseux par exemple, il est souhaitable de générer et d'entretenir de l'effervescence. Les zones de genèse des bulles dans un verre sont appelées sites de nucléation.

Il a été constaté que la présence d'irrégularités dans les surfaces de récipient au contact de boisson gazeuse augmente l'agglomération du gaz dissous dans la boisson et l'apparition de bulles. Pour favoriser le bullage, des surfaces intérieures présentant un relief rugueux ont donc été créées dans des contenants. Lors du remplissage du contenant avec un liquide carbonaté tel qu'une boisson gazeuse, des anfractuosités de la surface intérieure emprisonnent des poches d'air. Les interfaces entre le liquide et les poches d'air permettent de meilleurs échanges gazeux. Les anfractuosités forment alors des zones de nucléation.

Le brevet européen EP 0 703 743 au nom de Charles Glassware décrit un procédé d'apport de matière sur une surface pour créer des sites de nucléation et améliorer le bullage. La demande de brevet FR 2 531 891 déposée le 16 août 1983 décrit un procédé d'ablation de matière favorisant l'apparition de zone de dégagement gazeux. Des exemples d'application sont donnés dans la demande internationale WO 2010/048488 déposée le 23 octobre 2009.

La demanderesse a constaté que l'efficacité des récipients présentant des sites de nucléation artificiels était fortement réduite après la première utilisation. En particulier, les récipients présentant des zones rugueuses perdent leur propriété de génération de bulles lors d'utilisations répétées, par exemple dans les commerces de débits de boisson.

L'invention vient améliorer la situation.

La demanderesse propose un récipient pour boisson présentant des irrégularités de surface dans une région choisie. La région choisie est revêtue d'une couche hydrophobe. Les irrégularités forment des sites de nucléation à l'intérieur du récipient. Les sites de nucléation favorisent la formation de bulles au contact d'une boisson carbonatée.

Un tel récipient est déshumidifié plus rapidement à la suite d'un lavage. Les sites de nucléation s'assèchent rapidement. Le piégeage d'air dans les irrégularités lors du remplissage par une boisson est assuré, et ce même lorsque le remplissage a lieu à bref délai après un nettoyage. La préservation dans le temps des propriétés effervescentes du récipient est améliorée. La qualité et la quantité de la mousse sont améliorées.

Le récipient peut en outre comprendre une surface intérieure incluant la région choisie, les sites de nucléation prenant la forme de cavités et les cavités étant revêtues de la couche hydrophobe.

Le récipient peut en outre comprendre un corps en verre. La transparence permet de visualiser l'apparition et le cheminement des bulles depuis le site de nucléation jusqu'à la surface de la boisson.

Selon un autre aspect, la demanderesse propose un procédé pour créer des sites de nucléation à l'intérieur d'un récipient pour boisson et favoriser la formation de bulles au contact d'une boisson carbonatée. On crée des irrégularités de surface dans une région choisie du récipient. On dépose ensuite une couche hydrophobe sur la région choisie.

Les récipients ainsi créés présentent des irrégularités favorisant la déshumidification. Le remplissage des irrégularités par de l'humidité est limité. Les propriétés de bullage des sites de nucléation ne sont pas neutralisées par le remplissage avec du liquide. L'humidité résultant d'un nettoyage du récipient entre deux utilisations tend à migrer hors des irrégularités. La durabilité des propriétés de bullage du récipient est augmentée.

La création des irrégularités de surface dans une région choisie du récipient peut en outre comprendre les étapes suivantes :
a. prévoir une ébauche de récipient pour boisson présentant une surface intérieure,
b. créer des cavités dans la surface intérieure de l'ébauche dans une région choisie, et
c. obtenir un récipient pour boisson à partir de l'ébauche en conservant lesdites cavités.

Le procédé peut en outre présenter les caractéristiques suivantes, en combinaisons ou non :
- L'étape b comprend une opération d'apport de matière sur la surface intérieur de l'ébauche et/ou un retrait de matière de la surface intérieur de l'ébauche. Le procédé peut ainsi être mis en oeuvre sur des récipients existants ou à la suite d'une chaîne de fabrication existante. La forme, les dimensions et les propriétés mécaniques du récipient existant sont peu ou pas altérés par le procédé.
- L'ébauche comprend un corps à base de verre. L'étape b comprend une opération de dépôt d'émail sur ledit corps. Le dépôt d'émail permet la création d'irrégularités présentant une bonne tenue mécanique dans le temps.
- L'étape b comprend l'ajout d'au moins un dopant à l'émail. Le dopant est choisi parmi les oxydes métalliques réfractaires, de préférence les silicates. Les oxydes métalliques réfractaires résistent aux traitements thermiques utilisés pour la fixation de l'émail à l'ébauche. La structure du dopant est préservée. La rugosité et les cavités formées s'en trouvent améliorées.
- L'étape b comprend une opération de tampographie. Un ajout de dopant à l'émail est réalisé avant l'opération de tampographie. L'opération de tampographie est rapide et peu coûteuse. Cette technique permet de définir précisément les zones à traiter. La source des bulles peut être choisie de manière précise.
- Le dépôt de la couche hydrophobe comprend une opération de dépôt chimique en phase vapeur. Le dépôt chimique en phase vapeur présente une reproductibilité élevée. Les tolérances d'épaisseur de la couche hydrophobe sont faibles. Une couche très mince peut être déposée.
- Le dépôt chimique en phase vapeur est réalisé au moyen d'un précurseur. Le précurseur comprend un composé organo-métallique. Le précurseur comprend par exemple de l'hexaméthyldisilane.
- Le dépôt chimique en phase vapeur est réalisé au moyen d'une torche à plasma. Le dépôt chimique est discontinu d'une ébauche à une autre. L'accessibilité du fond d'une ébauche de récipient est limitée alors qu'il est généralement souhaitable de traiter précisément le fond. Une torche à plasma permet une bonne sélectivité des zones à traiter, même quand celles-ci sont difficilement accessibles. Il est par ailleurs souhaitable d'éviter de traiter d'autres zones que celles prévues. L'immobilité relative de l'ébauche et de la torche au cours du dépôt chimique donne satisfaction.

D'autres caractéristiques, détails et avantages de l'invention apparaitront à la lecture de la description détaillée ci-après, et des dessins annexés, sur lesquels :
- la figure 1 est une vue en coupe d'une ébauche de récipients,
- la figure 2 est une vue en coupe d'un état intermédiaire au cours du procédé selon l'invention,
- la figure 3 est une vue en coupe et en détail d'un récipient selon l'invention,
- la figure 4 est une vue similaire à la figure 3 en présence d'une boisson carbonatée,
- la figure 5 est une représentation d'un mode de réalisation du procédé selon l'invention, et
- la figure 6 est une vue de dessus d'un récipient selon l'invention.

Les dessins et la description ci-après contiennent, pour l'essentiel, des éléments de caractère certain. Ils pourront donc non seulement servir à mieux faire comprendre la présente invention, mais aussi contribuer à sa définition, le cas échéant.

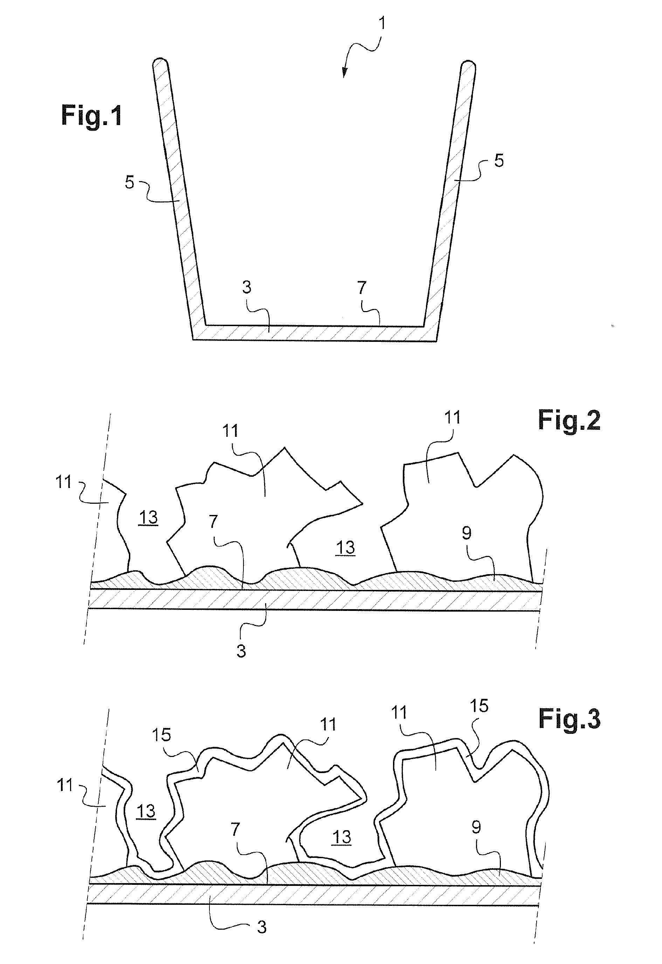

Une ébauche 1 de récipient est représentée en figure 1. L'ébauche 1 prend, ici, la forme d'un verre à boire. Dans des variantes, l'ébauche 1 prend la forme d'une chope à bière, d'une flûte à champagne, ou tout autre contenant adapté pour accueillir une boisson gazeuse. Le procédé décrit dans la suite s'applique à la plupart des récipients pour boisson carbonatée ou boisson gazeuse pour lesquels la maîtrise de l'effervescence présente un intérêt.

L'ébauche 1 est, ici, constituée d'un fond 3 sensiblement plan et d'une paroi 5 latérale de forme sensiblement tronconique. L'ébauche 1 est, ici, axisymétrique. Dans l'exemple décrit ici, le fond 3 et la paroi 5 forment un corps monobloc. Le corps porte une surface intérieure 7. La surface intérieure 7 s'étend à la fois sur le fond 3 et sur la paroi 5. La surface intérieure 7 est destinée à être au contact de la boisson lors de l'utilisation du récipient.

L'ébauche 1 de récipient peut être obtenue par des techniques de fabrication connues en tant que telles, par exemple par pressage, soufflage et/ou par centrifugation. En sortie, la surface intérieure 7 de l'ébauche 1 est sensiblement lisse et uniforme.

Dans l'exemple décrit dans la suite, une partie seulement de la surface intérieure 7 du fond 3 est traitée. D'autres parties peuvent être traitées en fonction de la localisation souhaitée de la source de bulles dans le récipient achevé.

Dans un premier mode de réalisation, un émail 9 est déposé sur la surface intérieure 7 lisse. L'émail 9 est déposé par tampographie. Un tampon portant une surface d'application texturée est utilisé. La surface d'application du tampon présente en négatif les irrégularités souhaitées pour le site de nucléation. La surface d'application est d'abord enduite de l'émail 9. Ensuite, la surface d'application est appuyée contre la partie de la surface intérieure 7 à traiter. L'émail 9 est transféré sur la partie de la surface intérieure 7 à traiter. L'ébauche 1 de récipient portant l'émail 9 est cuite, par exemple sous une température comprise entre 600 et 800°C. L'émail 9 cuit adhère à une partie de la surface intérieure 7. L'émail 9, avant enduction sur le tampon, peut comprendre par exemple de l'encre sous la forme d'une pâte, un verre tendre de bisilicate au plomb et/ou du verre tendre de bisilicate mélangé avec des charges minérales, des résines organiques et/ou un solvant. La formulation de l'émail 9 est sélectionnée de manière à former des irrégularités aptes à former des sites de nucléation à l'état final du récipient tout en assurant une bonne adhésion à l'ébauche 1.

La tampographie permet, par ajout de matière, de créer des irrégularités de surface de manière maîtrisée et localisée sur la partie de la surface intérieure 7 à traiter.

Dans des variantes, la fixation de l'émail 9 sur une partie de la surface intérieure 7 est réalisée par impression par jet d'encre, transfert thermique et/ou tout autre moyen adapté. La coloration et la transparence sont sélectionnées par l'absence ou l'ajout de pigments colorants.

Le relief de l'émail 9 cuit présente des irrégularités. La partie à traiter de la surface intérieure 7 est rendue rugueuse de manière contrôlée par l'apport d'émail 9. Les irrégularités comprennent, ici, des cavités 13 ouvertes. Les cavités 13 ouvertes peuvent être obtenues au moins en partie par apport de matière et/ou par retrait de matière. Le retrait de matière peut être obtenu par application d'un laser, par action mécanique telle le sablage ou le ponçage, ou encore par attaque chimique. Les cavités 13 forment des sites de nucléation du récipient en utilisation.

Dans un second mode de réalisation, l'émail 9 est en outre dopé. La composition d'un dopant 11 est sélectionnée en fonction des compatibilités chimiques avec l'émail 9. Le dopant 11 est de préférence non polluant, sensiblement exempt de métaux lourds et apte au contact alimentaire. Le dopant 11 peut comprendre des oxydes métalliques réfractaires, préférentiellement des silicates seuls ou en complément d'un autre composant du dopant 11. Les silicates peuvent par exemple comprendre des silicates d'alumine tels ceux référencés "104246 Iriodin® 103 Rutile Sterling Silver" et commercialisés par la société Merck.

Dans un mode de réalisation, le dopant 11 est mélangé à l'émail 9 avant cuisson et avant application sur l'ébauche 1 de récipient. La quantité de dopant 11 ajoutée à l'émail 9 peut atteindre entre 1 et 30% en masse de l'émail dopé, préférablement 5 à 12%, par exemple environ 10% avec une granulométrie de 10 à 60 micromètres. L'émail dopé est ensuite appliqué et solidifié sur la partie de la surface intérieure 7 selon l'une des méthodes citées ci-avant. Le dopage selon ce mode de réalisation présente une bonne reproductibilité. Les quantités de dopant 11 présentent une bonne homogénéité dans la surface traitée. Le gaspillage de dopant 11 est évité. L'utilisation d'un moyen d'élimination/récupération de surplus est inutile. Le dopage permet l'augmentation du relief formé par l'émail dopé. L'émail dopé est plus rugueux. L'émail dopé aux silicates d'alumine est plus réfractaire. Le volume moyen et la profondeur moyenne des cavités 13 sont plus importants qu'en l'absence de dopage. D'autres méthodes de dopage peuvent être utilisées, par exemple par saupoudrage de dopant 11 après enduction de l'émail 9 et avant cuisson. Le dopage reste néanmoins optionnel.

Les compositions de l'émail 9 et des éventuels dopants 11 présentent une bonne innocuité, notamment à l'état final du récipient. Des composants de qualité alimentaire et stables au contact de boissons gazeuses sont utilisés. Les normes sanitaires s'appliquant aux contenants alimentaires sont respectées. L'utilisation de métaux lourds est évitée.

La figure 2 représente une partie de la surface intérieure 7 après application de l'émail 9 comprenant du dopant 11. La partie de la surface intérieure 7 à traiter présente maintenant des cavités 13.

Entre l'état représenté en figure 2 et l'état représenté en figure 3, la surface intérieure 7 subit une étape de dépôt d'une couche hydrophobe 15, par exemple un film. On entend ici par couche hydrophobe une substance sensiblement insoluble dans l'eau et dans les produits polaires, disposée sur une surface de manière à former une barrière hydrofuge.

Dans d'autres domaines techniques que celui de l'invention, les compositions hydrophobes sont généralement appliquées par pulvérisation. Les techniques de pulvérisation connues ne permettent pas toujours d'atteindre une précision suffisante, notamment en épaisseur de dépôt, en homogénéité ou en délimitation de la surface traitée.

Dans les exemples décrits ici, la couche hydrophobe 15 est déposée par dépôt chimique en phase vapeur, ou CVD pour "Chemical Vapor Déposition". Un plasma est créé sur la partie de la surface intérieure 7 à traiter. La partie de la surface intérieure 7 à traiter est, ici, recouverte d'émail 9 comprenant du dopant 11. Un précurseur est injecté dans le plasma. Le précurseur réagit sur les surfaces libres, notamment sur la partie de la surface intérieure 7 à traiter incluant les surfaces intérieures des cavités 13. La couche hydrophobe 15 ainsi formée présente une bonne homogénéité. En particulier l'épaisseur de la couche hydrophobe 15 est homogène dans les cavités 13, et ce quelles que soient les formes des cavités 13. Contrairement à un dépôt orienté tel qu'une pulvérisation, le dépôt chimique en phase vapeur présente une bonne efficacité sur les portions de surfaces qui ne sont pas orientées directement vers la source de la matière déposée. En variante, d'autres méthodes de dépôt sont utilisées.

La couche hydrophobe 15 ainsi créée présente une bonne durabilité. Des tests effectués par la demanderesse ont montré une résistance de la couche hydrophobe supérieure à 500 cycles de deux minutes de lavage dans de l'eau à 60°C comprenant 1,5 gramme par litre de détergent. Par ailleurs, la couche hydrophobe 15 peut être déposée sur une épaisseur inférieure ou égale à 100 nanomètres. Les cavités 13 présentent une ouverture équivalente à un diamètre compris entre 50 et 150 micromètres. La couche hydrophobe 15 présente une faible épaisseur par rapport aux dimensions des irrégularités de surface et des cavités 13. Le dépôt de la couche hydrophobe 15 préserve les irrégularités. La couche hydrophobe n'obture pas les cavités 13. Les sites de nucléations sont préservés. Le dépôt chimique en phase vapeur est propre et non destructif.

Le précurseur comprend, ici, de l'hexaméthyldisilane. En variante, le précurseur comprend d'autres composés organo-métalliques et de préférence un organosilane, par exemple de l'hexaméthyldisiloxane ou du tetraethoxysilane. Le précurseur est choisi pour ses caractéristiques physico-chimiques, telles la viscosité, la masse molaire et la réactivité chimique, de sorte que la couche créée présente une bonne compatibilité alimentaire.

Dans un premier mode de réalisation, le gaz plasmagène utilisé est l'air atmosphérique, soit environ quatre cinquièmes de diazote N₂ pour un cinquième de dioxygène O₂. Le dépôt est réalisé sous pression atmosphérique.

Dans un second mode de réalisation préféré, le gaz plasmagène utilisé comprend essentiellement du diazote N₂. L'absence ou la quasi-absence de dioxygène O₂ dans le gaz plasmagène limite les réactions d'oxydation du dioxygène O₂ avec la surface intérieure 7 de l'ébauche 1. Les réactions non contrôlées formeraient par exemple de la silice SiO₂. La silice SiO₂ déposée de manière incontrôlée tend à former un voile blanchâtre nuisant à la transparence. La formation de silice SiO₂ de mauvaise qualité optique n'est pas souhaitable notamment pour des raisons esthétiques. En particulier, il est préférable que la paroi 5 de l'ébauche 1 reste transparente.

Dans une variante, le gaz plasmagène comprend en outre du méthane CH₄. Le carbone C du méthane CH₄ réagit avec le dioxygène O₂ de l'air ambiant pour former du dioxyde de carbone CO₂. La consommation du dioxygène O₂ limite encore les réactions incontrôlées décrites ci-avant. Par ailleurs, la présence de méthane CH₄ améliore les propriétés hydrophobes de la couche hydrophobe 15 en favorisant la création de liaisons Si-C. La couche hydrophobe 15 est en outre mécaniquement résistante.

De manière générale, la composition du gaz plasmagène est adaptée à l'espace confiné à l'intérieur de l'ébauche 1 de récipient pour maîtriser l'environnement chimique dans lequel est réalisé le dépôt.

Dans l'exemple décrit ici, le dépôt en phase vapeur est réalisé au moyen d'une torche à plasma 31. Par exemple, une torche référencée "ULS" et commercialisée par la société ACXYS peut être utilisée. Une tête 31 de la torche à plasma 31 peut être appliquée sur la zone à traiter, c'est-à-dire ici une partie de la surface intérieure 7 du fond 3. L'utilisation d'une torche à plasma 31 autorise une grande précision dans la délimitation des zones à traiter. En appliquant la tête 33 de la torche à plasma 31 seulement à proximité de la partie de la surface intérieure 7 à traiter, la pollution des surfaces qui ne sont pas à traiter est limitée. Le plasma est créé seulement à proximité des zones à traiter.

Dans une variante, un carter est fixé autour de la tête 33 de la torche à plasma 31. Le carter présente alors une forme tronconique s'ouvrant en direction des zones à traiter. Le carter permet d'encore mieux confiner le plasma, les gaz plasmagènes et le précurseur à proximité des zones à traiter. La précision du traitement est encore améliorée. La pollution des zones qui ne sont pas à traiter est encore réduite. Bien qu'avantageux, le carter peut être omis.

Dans une autre variante, combinée ou non avec la présence du carter, la torche à plasma 31 est activée seulement lorsque la tête 33 est dans une position de travail. En position de travail, la tête 33 est disposée au plus près de la zone à traiter. Par activée, on entend ici que la tête 33 est mise sous tension de manière à ce qu'un plasma soit créé et maintenu. Dans ce cas, la précision du traitement est améliorée. Les réactions sur les zones qui ne sont pas à traiter sont limitées. Un tel fonctionnement est efficace à des cadences de traitement faibles. Par exemple de petites séries de récipients peuvent être réalisées par un opérateur manipulant la torche à plasma 31.

Dans des conditions industrielles, il est souhaitable que la fabrication de tels récipients soit automatisée. En particulier, il est souhaitable qu'un procédé de création de sites de nucléation soit au moins aussi rapide que la fabrication de l'ébauche 1 elle-même. Ainsi, un poste automatisé ou semi-automatisé apte à mettre en oeuvre le procédé de création de sites de nucléation peut être aisément intégré à une chaîne de fabrication classique et existante. En outre, l'automatisation permet d'améliorer la reproductibilité des opérations. De telles chaînes de fabrication sont capables de fabriquer environ 60 ébauches par minute.

En outre, la présence d'un carter 35 nécessite un nettoyage fréquent pour éliminer les dépôts parasites qui ont lieu sur le carter 35. De telles contraintes ne sont pas souhaitables, en particulier dans un contexte industriel et à des cadences élevées.

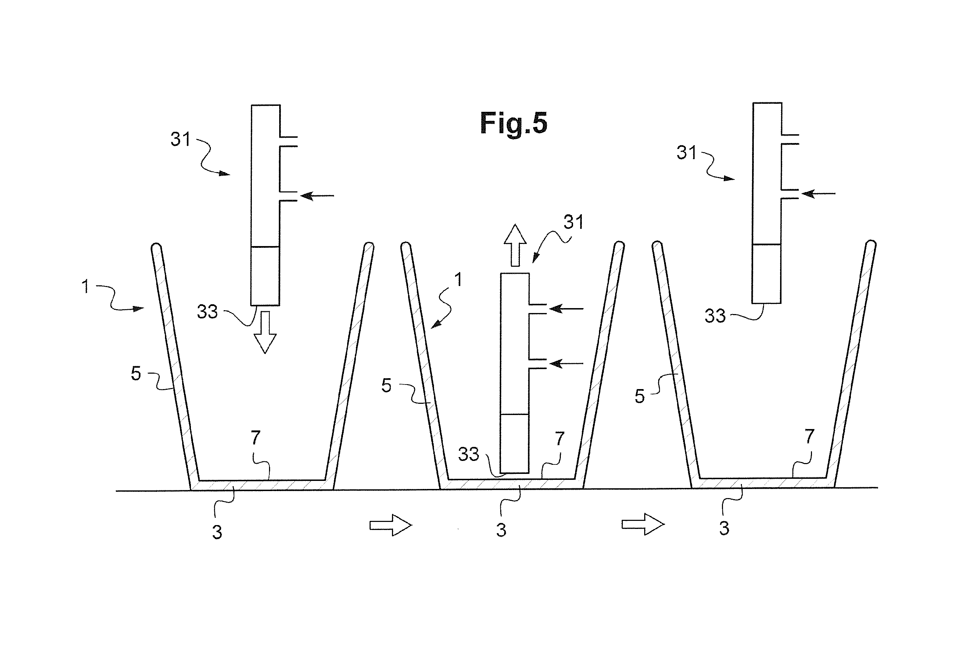

La demanderesse a développé une variante particulièrement adaptée à la production automatisée, sans pour autant s'y limiter. Cette variante est représentée en figure 5. La torche à plasma 31 est maintenue sous tension non seulement lors du traitement dans une position de travail contre la surface intérieure 7 du fond 3, mais également lors de déplacements soit pour venir au contact, soit pour être retirée du fond 3 de l'ébauche 1. Les allumages et extinctions du plasma sont limités. La distribution du précurseur est stoppée lors du déplacement de la torche à plasma à l'intérieur de l'ébauche 1. L'arrivée du précurseur est active seulement lorsque la tête 33 de la torche à plasma 31 est en position de travail, placée au contact de la zone à traiter, soit ici la surface intérieure 7 du fond 3. Les réactions non-contrôlées sur les surfaces qui ne sont pas à traiter sont limitées. Le dépôt chimique est discontinu d'une ébauche à une autre.

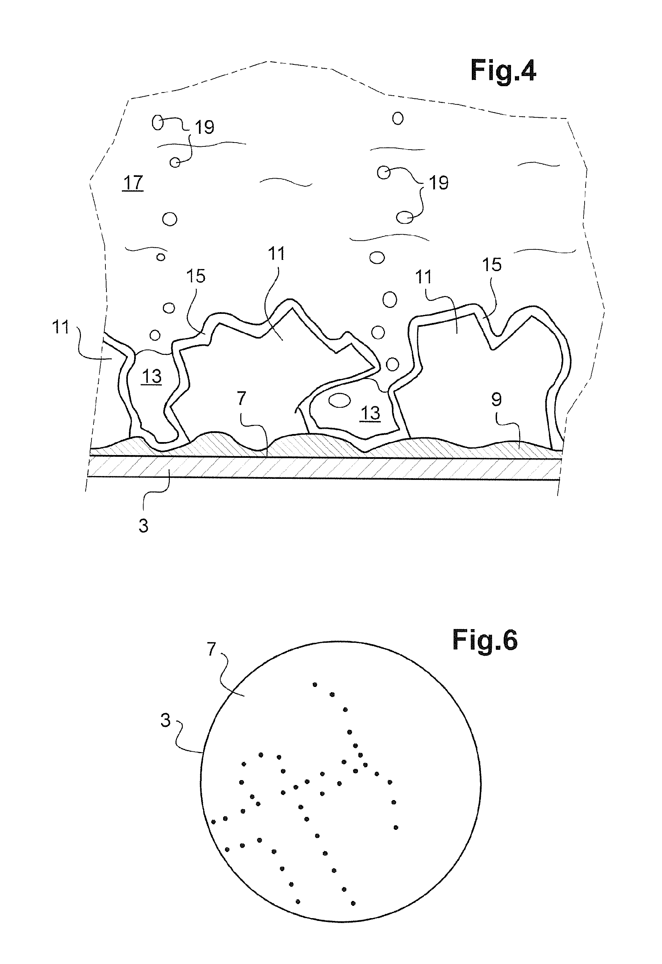

Un exemple de la structure obtenue en figure 4 est représenté en utilisation en figure 5. Une boisson gazeuse 17, par exemple de la bière, est contenue dans le récipient. Lors du remplissage par la boisson gazeuse 17, la cavité 13 loge des bulles d'air. L'interface air-boisson gazeuse 17 favorise l'effervescence et le bullage. Des bulles 19 de gaz se créent et s'échappent vers la surface de la boisson 19 sous l'effet de la poussée d'Archimède. Le site de nucléation ainsi créé peut aussi être appelé "point mousse".

Après une première utilisation, les récipients ainsi utilisés sont généralement nettoyés. Lors du nettoyage, de l'eau et/ou du solvant tendent à être piégés dans les irrégularités. Ce phénomène est accentué par les techniques industrielles de lavage et notamment l'utilisation d'un lave-vaisselle. Un récipient présentant une surface intérieure pourvue d'au moins un site de nucléation incluant au moins une cavité 13 dont l'intérieur est revêtu d'une couche hydrophobe 15 permet d'évacuer très rapidement l'eau et les solvants des cavités 13, voire même d'empêcher leur intrusion dans les cavités 13. Le séchage est accéléré, et notamment dans les cavités 13. Lors du second versage d'une boisson gazeuse 17, les cavités 13 emplies d'air piègent à nouveau l'air sous la boisson gazeuse 17. Grâce à la couche hydrophobe 15, le piégeage d'air dans les cavités 13 est amélioré et durable. L'effervescence s'en trouve améliorée non seulement en quantité mais aussi en répétabilité tout au long de l'utilisation du récipient.

La figure 6 représente un exemple d'un fond de récipient pourvu de plusieurs sites de nucléation incluant chacun au moins une cavité dont l'intérieur est revêtu d'une couche hydrophobe. Le choix des zones à traiter permet de former des symboles ou des images, par exemple dans un but publicitaire.

L'invention ne se limite pas aux exemples de procédés et de récipients décrits ci-avant, seulement à titre d'exemple, mais elle englobe toutes les variantes que pourra envisager l'homme de l'art dans le cadre des revendications ci-après.

## Revendications

1. Récipient pour boisson présentant des irrégularités de surface dans une région choisie, la région choisie étant revêtue d'une couche hydrophobe (15), les irrégularités formant des sites de nucléation à l'intérieur du récipient, les sites de nucléation favorisant la formation de bulles au contact d'une boisson carbonatée.

2. Récipient selon la revendication 1, comprenant en outre une surface intérieure (7) incluant la région choisie, les sites de nucléation prenant la forme de cavités (13), les cavités (13) étant revêtues de la couche hydrophobe (15).

3. Procédé pour créer des sites de nucléation à l'intérieur d'un récipient pour boisson et favoriser la formation de bulles au contact d'une boisson carbonatée, dans lequel on crée des irrégularités de surface dans une région choisie du récipient, **caractérisé en ce que** l'on dépose ensuite une couche hydrophobe (15) sur ladite région choisie.

4. Procédé selon la revendication 3, dans lequel la création des irrégularités de surface dans une région choisie du récipient comprend les étapes suivantes :
a. prévoir une ébauche (1) de récipient pour boisson présentant une surface intérieure (7),
b. créer des cavités (13) dans la surface intérieure (7) de l'ébauche (1) dans une région choisie, et
c. obtenir un récipient pour boisson à partir de l'ébauche (1) en conservant lesdites cavités (13).

5. Procédé selon la revendication 4, dans lequel dans lequel l'étape b comprend une opération d'apport de matière sur la surface intérieur (7) de l'ébauche (1) et/ou un retrait de matière de la surface intérieur de l'ébauche (1).

6. Procédé selon l'une des revendications 4 et 5, dans lequel l'ébauche (1) comprend un corps à base de verre et dans lequel l'étape b comprend une opération de dépôt d'émail (9) sur ledit corps.

7. Procédé selon la revendication 6, dans lequel l'étape b comprend l'ajout d'au moins un dopant (11) à l'ébauche (1), le dopant (11) étant choisi parmi les oxydes métalliques réfractaires, de préférence les silicates.

8. Procédé selon la revendication 7, dans lequel l'étape b comprend une opération de tampographie, l'ajout du dopant (11) à l'émail étant réalisé avant l'opération de tampographie.

9. Procédé selon l'une des revendications précédentes, dans lequel le dépôt de la couche hydrophobe (15) comprend une opération de dépôt chimique en phase vapeur.

10. Procédé selon la revendication 9, dans lequel le dépôt chimique en phase vapeur est réalisé au moyen d'un précurseur organo-métallique.

11. Procédé selon la revendication 10, dans lequel le précurseur organique comprend de l'hexaméthyldisilane.

12. Procédé selon l'une des revendications 9 à 11, dans lequel le dépôt chimique en phase vapeur est réalisé au moyen d'une torche à plasma (31), le dépôt chimique étant discontinu d'une ébauche (1) à une autre.
